(19) Europäisches Patentamt / European Patent Office / Office européen des brevets

(11) **EP 4 431 950 B1**

(12) **EUROPEAN PATENT SPECIFICATION**

(45) Date of publication and mention of the grant of the patent:
**22.04.2026 Bulletin 2026/17**

(21) Application number: **23161743.2**

(22) Date of filing: **14.03.2023**

(51) International Patent Classification (IPC):
**G01R 1/20** (2006.01) **G01R 1/44** (2006.01)
**G01R 19/00** (2006.01) **H01C 7/06** (2006.01)
**G01R 35/00** (2006.01) **G01R 35/02** (2006.01)
**H01C 13/02** (2006.01)

(52) Cooperative Patent Classification (CPC):
**G01R 1/203; G01R 1/44; G01R 19/0092;
H01C 7/06;** G01R 35/005; G01R 35/02; H01C 13/02

(54) **CURRENT SENSOR ASSEMBLY, AND METHOD FOR DETERMINING A TEMPERATURE OF A RESISTOR ARRANGEMENT**

STROMSENSORANORDNUNG UND VERFAHREN ZUM BESTIMMEN EINER TEMPERATUR EINER WIDERSTANDSANORDNUNG

ENSEMBLE DE CAPTEURS DE COURANT ET PROCÉDÉ DE DÉTERMINATION D'UNE TEMPÉRATURE D'UN ENSEMBLE DE RÉSISTANCES

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(43) Date of publication of application:
**18.09.2024 Bulletin 2024/38**

(73) Proprietor: **Munich Electrification GmbH**
**81373 Munich (DE)**

(72) Inventors:
• **Goede, Stefan**
**80799 Munich (DE)**
• **Kleppe, Sebastian**
**80637 Munich (DE)**

(74) Representative: **Grünecker Patent- und Rechtsanwälte**
**PartG mbB**
**Leopoldstraße 4**
**80802 München (DE)**

(56) References cited:
**WO-A1-2020/160979 DE-A1- 102019 218 308
US-A1- 2017 089 955 US-A1- 2020 011 905
US-A1- 2022 057 438 US-A1- 2023 009 467**

## Description

The present disclosure relates to a current sensor assembly comprising a resistor arrangement, and a method for determining a temperature of a resistor arrangement.

For current measurements in electronic circuits, measuring resistors are used which are connected in series with a component to be monitored, whereby a current to be measured can be determined from the voltage dropping across the measuring resistor, which is often also referred to as a shunt resistor or shunt for short. Correct and reliable current measurement is particularly important, for example, in a battery management system of a hybrid or electric vehicle or for monitoring a fuel cell device.

Such a low-resistance measuring resistor as a shunt with approximately 10 - 50 $\mu$Ohm can be made from a longitudinally welded composite material strip. This is known, for example, from EP 0 605 800 A1. The composite material is produced from three material strips by joining the individual metal strips to each other, each via a longitudinal seam, by an electron beam or laser welding process.

The demands on correct and reliable current measurement in the present hybrid and electric vehicles, in which in some cases driving or charging occurs at very high continuous currents, are increasing. With such currents, it is of great importance to monitor the safety-relevant components. In this context, the Li-ion batteries with their high energy density must be closely monitored in order to ensure they are always in a safe state of operation. The current measurement in the battery is therefore imperative for monitoring certain operating parameters such as the state of charge (SOC/state of charge) or the operating state (SOH/state of health) or the proper function (SOF/state of function). With a safety level in this area of application of up to ASIL C and D (as defined in ISO 26262:2018), it is necessary to protect the relevant measuring instruments via a redundant function so that the safety level can be implemented at all.

The redundancy of the current measurement, which is necessary to achieve the safety level ASIL C, can be achieved by the combination of different sensors, i.e. the simultaneous acquisition of two completely different measurement signals, for example by a voltage measurement at a shunt resistor of known size and by a measurement of the Hall voltage on an current-carrying conductor in a magnetic field. However, this setup is associated with relatively high costs, also because the integration is low and many components with a correspondingly high installation space requirement are needed.

The redundancy in the measured value acquisition can also be achieved by connecting a second shunt resistor in series to the first shunt resistor, instead of using the Hall voltage measurement, and by performing an independent voltage measurement on each of the two shunt resistors of the double shunt thus formed to determine the current strength. By comparing the two measurements, it can then be determined whether the measurements are plausible or whether there is an error. The double shunt thus enables the diagnosis of "single point faults", namely of drift, change in resistance, or de-contacting of individual measurement taps. It further offers better diagnosis options for the shunt electronics by means of a plausibility check of the measurement by two shunt elements integrated in one component. The structure of the current measurement using a double shunt is simpler and less expensive than a current measurement using a single shunt and an additional Hall sensor.

The possibility of producing a multiple shunt is known from for example from EP 3 851 859 A1, which discloses to integrate two resistance elements formed of different resistance materials into a resistance arrangement. However, such arrangement requires that each of the two resistance elements has two welding joints with respective conductive contact elements, so that a minimum of four welding joints is provided. These welding joints limit the minimum resistance of the resistor arrangement, since a length of the resistance material between the conductive elements, which defines a resistance of the corresponding resistance element, cannot arbitrarily be reduced, because if the resistance material becomes too thin welding is not possible anymore. The welding joints also contribute significantly to the production cost of the resistor arrangement. Furthermore, to compensate the material specific temperature coefficients, it is necessary to sense the temperature of the resistance elements with an external temperature sensor, which may introduce measurement errors and limitations due to the thermal connection, which is required between the resistance element and the external temperature sensor.

US 2022/057438 A1 discloses a current sensor element, which comprises at least one resistance section, a first electrically conductive connection section connected to a first end of the resistance section, and a second electrically conductive connection section connected to a second end of the resistance section. The first electrically conductive connection section comprises a first voltage measurement contact, wherein the second electrically conductive connection section comprises a second voltage measurement contact and at least one third voltage measurement contact.

DE 10 2019 218308 A1 relates to a resistor assembly for a current sensor with at least two measuring resistors arranged in series. At least a first voltage tapping point is arranged before the first measuring resistor and at least one second voltage tapping point is arranged behind the last measuring resistor. At least one second voltage tapping point is arranged between adjacent measuring resistors.

US 2017/089955 A1 discloses an electrical current detection device provided with a shunt resistor that includes a first conducting part, a second conducting part, a center conducting part disposed between the first conducting part and the second conducting part, a first resistor disposed between the first conducting part and the center conducting part, and a second resistor disposed between the second conducting part and the center conducting part, the second resistor having a greater resistance value than the first resistor.

US 2023/009467 A1 discloses a current measurement device for measuring the current of a power storage element. The current measurement device comprises a measurement resistor unit that is positioned on a current path and comprises a resistor, a pair of detection points that are positioned on the current path on both sides of the resistor, a current detection unit that comprises a pair of voltage input units that are connected to the pair of detection points and detects the current of the power storage element from the voltage difference between the pair of detection points, and a ground connection point that is connected to a common ground GND with the current detection unit.

WO 2020/100979 A1 discloses a current-determining device, which determines a current by using a complex resistance of a measuring section of a line.

US 2020/011905 A1 discloses a current sensor, which has a current feed contact for electrically contacting a device for providing a calibration current.

In this respect, the inventors of the present invention have recognized that there is still a need to provide a resistance arrangement and a corresponding current sensor assembly improving performance and reliability of the sensor output and facilitating the manufacturing process, thereby overcoming, or at least substantially reducing the above mentioned problems and drawbacks.

At least one of these objects is solved by the subject matter of the present invention as defined in the independent claims. Advantageous embodiments of the present invention are the subject matter of the dependent claims.

The present invention is based on the idea of directly integrating a predefined resistance as a second resistance element in one of the two conductive connection elements, which are welded to a first resistance element to form the resistor arrangement, by geometrically forming a well-defined resistance in the respective conductive connection element. By forming the second resistance element from a section of the conductive connection element, it is possible to reduce the number of welding joints required in the resistance arrangement. Accordingly, the total resistance of the resistor arrangement can be reduced, so that power losses can be minimized. Further, the integration of the predefined resistance into one of the two conductive connection elements allows to improve the temperature determination of the resistor arrangement and specifically of the first resistor element in order to improve the accuracy of the current determination, since the temperature can be directly sensed by the resistance section integrated into the conductive connection elements.

In particular, a resistor arrangement according to a first aspect comprises a first electrically conductive connection element and a second electrically conductive connection element, which are formed of a first electrically conductive material having a first specific electrical conductivity, a first resistance element formed of a first resistance material having a second specific electrical conductivity, which is lower than the first specific electrical conductivity, wherein the first resistance element is connected with a first end to the first electrically conductive connection element and with a second end to the second electrically conductive connection element. The first electrically conductive connection element comprises a terminal connection section, which is configured to be electrically connected to an external conductor of an electrical circuit, an intermediate connection section, which is connected with the first end of the resistance element, and a resistance section, which is arranged in between the terminal connection section and the intermediate section. According to the present disclosure the first resistance element has a first predefined resistance, and wherein the resistance section of the first electrically conductive connection element has a second predefined resistance.

In this manner, the resistor arrangement can reduce the total resistance introduced in an electric circuit for measuring a current, while the resistor arrangement allows for an enhancement of the temperature determination and a redundant current measurement. Thereby, it is especially beneficial that the first resistance element and the resistance section of the first electrically conductive connection element are specifically made of different materials, which in particular may have different chemical compositions, wherein in particular CuMn10Ni4 and CuMn12Ni2 and CuMn14Ni2 and CuZn15Mn150Al can be named as examples of the first resistance material forming the first resistance element, and wherein in particular copper (Cu) or aluminum (Al) can be named as examples of the first electrically conductive material forming the resistance section.

Here it should be noted that throughout this document, the term "predefined resistance" can refer to a nominal value of the resistance the respective resistance element or of the resistance section, which is includes an uncertainty due to manufacturing tolerances, or can refer to a calibrated value, which has been individually determined for the respective resistance element or resistance section after manufacturing the resistor arrangement.

In order to reduce the power loss in the resistor arrangement, according to a second aspect, the second predefined resistance is smaller than the first predefined resistance.

In order to allow an independent current determination, according to a third aspect the resistor arrangement may further comprise a first measuring contact pair for measuring a first electrical voltage dropping across the first resistance element and a second measuring contact pair for measuring a second electrical voltage dropping across the resistance section of the first electrically conductive connection element, wherein a first measuring contact from the first measuring contact pair and a second measuring contact from the second measuring contact pair are arranged on the intermediate connection section of the first electrically conductive connection element. Hereby, it is possible, depending on application scenarios and the measurement configuration, that the first measuring contact pair and the second measuring contact pair share a measuring contact arranged on the intermediate connection section.

In order to allow a better adjustment of the second predefined resistance, according to a fourth aspect, the resistance section may include a constriction, which has a predetermined geometrical shape. For example, the first electrically conductive element may be punched, stamped or cut out in order to a constriction with a predefined shape, which provides the second predefined resistance between a measuring contact pair. However, it is clear for the skilled person that it is not required to provide the constriction, but the resistance section may be formed as a region of the first electrically conductive element between a measuring contact pair, which has a total resistance corresponding to the second predefined resistance.

According to a fifth aspect the first electrically conductive connection element may be formed in such a way that a minimum thickness of the resistance section is smaller than a minimum thickness of the terminal connection section and a minimum thickness of the intermediate connection section and/or that a minimum width of the resistance section is smaller than a minimum width of the terminal connection section and a minimum width of the intermediate connection section. This configurations enhances the possibilities to adjust the second predefined resistance and also offers advantages when mounting the resistor arrangement on a PCB (printed circuit board), for example, or when soldering the resistor arrangement to another circuit component.

According to a sixth aspect, only the terminal connection section of the first electrically conductive connection element and the second electrically conductive connection element comprise connection means for integrating the resistor arrangement into an electric circuit. As a result, material and space are saved because the intermediate connection section only has the function of receiving connections for the voltage measurement, but not devices for connecting to an electric circuit, so that the intermediate connection section is not intended to be directly connected to the electric circuit. On its own, the resistor arrangement according to the first to sixth aspect as presented in the foregoing is not falling under the claimed subject-matter.

According to a seventh aspect, and falling under the claimed subject-matter, there is provided a current sensor assembly, which comprises the resistor arrangement according to one of the aspects, a first voltage tap for measuring a first electrical voltage dropping across the first resistance element, a second voltage tap for measuring a second electrical voltage dropping across the resistance section, and a measuring circuit, which is configured to measure the first electrical voltage and the second electrical voltage.

The measuring circuit is configured to perform the measurement of the first electrical voltage and of the second electrical voltage independently from one another, so that a failure of one of the two measuring chains can be recognized by comparing the two measurements.

The current sensor assembly further comprises a storage, which is configured to store a temperature coefficient of the first electrically conductive material, and a processing circuit, which is configured to determine a first current value of a current flowing through the resistor arrangement based on the first electrical voltage and the first predefined resistance, and a temperature of the resistance section of the first electrically conductive connection element based on the first current value, the second electrical voltage and the stored temperature coefficient of the first electrically conductive material. Especially, since the temperature coefficient of a material, which forms the first electrically conductive connection element and accordingly also the resistance section, usually has a linear temperature coefficient (e.g. $\alpha = 0,0039$ 1/K for copper or $\alpha = 0,004$ 1/K for aluminum) in the temperature range where the first resistor element is used, the temperature of the resistance section can be determined from the current flowing through the resistance section. This allows for directly measuring the temperature of the resistor arrangement with an element integrated into the resistance arrangement, so that the need for attaching an external temperature sensor is dispensed.

According to a tenth aspect, the current sensor assembly may further comprise a temperature sensor attached to the resistor arrangement, which is configured to measure a second temperature of the resistor arrangement, wherein the processing circuit may be further configured to compare the determined temperature of the resistance section to the second temperature, which is measured with the temperature sensor. Hereby, the second temperature may for example be measured by an NTC or another kind of resistance temperature sensor attached to the resistor arrangement. By comparing the determined temperature to the second temperature, it is possible to perform a consistency check of the temperature determined from the second voltage dropping across the resistance section, so that the safety level provided by the current sensor assembly can be enhanced. The consistency check can further help, for example, to detect a drift of the nominal resistance value of the resistance section and to detect a condition where a re-calibration of the resistance of the resistance section becomes beneficial.

According to an eleventh aspect, the processing circuit may be further configured to determine a second current value of the current flowing through the resistor arrangement based on the second electrical voltage and the second predefined resistance, and to compare the second current value to the first current value, in order to check consistency of the determined current values and to detect or diagnose measurement faults and/or "single point faults".

According to a twelfth aspect, there is provided a method for determining a temperature of the resistor arrangement according to one of the aspects. The method comprises the steps of acquiring, from a measuring circuit, measurement values of a measurement of a first electrical voltage dropping across the first resistance element and of a measurement of a second electrical voltage dropping across the resistance section of the first electrically conductive connection element, determining a first current value of a current flowing through the resistor arrangement based on the first electrical voltage and the first predefined resistance, and determining a temperature of the resistance section of the first electrically conductive connection element based on the first current value, the second electrical voltage and a stored temperature coefficient of the first electrically conductive material.

This method may be carried out for example by the processing circuit of the current sensor assembly, which can be a controller of the resistor arrangement provided on a circuit board attached to the resistor arrangement, but can also be an external controller, like a central controller of a battery management system (BMS) or an electronic control unit (ECU) of an electric vehicle or a hybrid electrical vehicle, which control the operation of electronic components in the electric circuit, in which the resistor arrangement is used.

Since the resistance section is formed of first electrically conductive material having a linear temperature coefficient (e.g. copper or aluminum), the resistance $R_2(T)$ of the resistance section depending on the temperature T can be determined according to the following equation (1):

$$R_2(T) = R_2(T_0) \cdot [1 + \alpha \cdot (T - T_0)] \tag{1}$$

wherein:

$\alpha$:      is the linear temperature coefficient of the material from which the first electrically conductive connection element (i.e. the resistance section) is formed (e.g. 0.0039 1/K for copper);

T:      is the temperature of the material of the resistance section;

$T_0$:      is the temperature at which a calibration step is performed (e. g. 20 °C);

$R_2(T_0)$:      is the resistance of the resistance section determined at the calibration temperature.

Equation (1) can be converted into the following equation (2), which gives the temperature as:

$$T = T_0 + \left[ \frac{R_2(T) - R_2(T_0)}{\alpha * R_2(T_0)} \right] \tag{2}$$

Accordingly, by using equation (2), it is possible to determine the temperature of the resistance section, which is closely arranged and accordingly in good thermal contact with the first resistance element from the determined resistance $R_2(T)$ of the resistance section at the temperature T, which follows equation (3):

$$R_2(T) = \frac{U_2}{I} = \frac{U_2 * R_1(T)}{U_1} \tag{3}$$

wherein:

$U_2$:      is the measured second voltage;

$U_1$:      is the measured first voltage; and

$R_1(T)$:      is the resistance of the first resistance element determined at the temperature T.

Equation (3) uses that the current I, which flows through the resistor arrangement is equal in the first resistance element and the resistance section, and can be determined by Ohm's law according to the following equation (4) Because the resistance section is directly thermally coupled with the resistance element the method allows for a more precise and dynamic determination of the temperature of the first resistance element. Hence the accuracy of a TCR (temperature coefficient ratio) correction of the resistance of the first resistance element can be greatly enhanced.

In order to dispense the need for using an additional temperature sensor, the determination of the temperature of the resistance section is iteratively repeated until the determined temperature converges. Usually, the temperature coefficient of the material, from which the first resistance element is formed, is a few orders of magnitude smaller than the temperature coefficient of the material, from which the resistance section of the first electrically conductive connection element is formed. Accordingly, after setting an arbitrary estimated starting temperature for determining the temperature of the resistance, when iteratively solving the above equations (2) and (3), the determined temperature converges to the actual temperature of the resistance section.

According to a fourteenth aspect, the method may further comprise a step of comparing the determined temperature of the resistance section with a second temperature, which is measured with a temperature sensor attached to the resistor arrangement. Hereby, the second temperature may for example be measured by a temperature sensor, like an NTC or other resistance temperature sensor, which is attached to the first electrically conductive connection element or to the second electrically conductive connection element. By comparing the determined temperature to the second temperature, it is possible to perform a consistency check of the temperature determined from the second voltage dropping across the resistance section, so that the safety level provided by the current sensor assembly can be enhanced. The consistency check can further help, for example, to detect a drift of the nominal resistance value of the resistance section and to detect a condition where a re-calibration of the resistance of the resistance section becomes beneficial.

In order to enhance the accuracy of the temperature detection and to compensate for drifts in the nominal resistance value of the resistance section, according to a fifteenth aspect the method may further comprise a calibration step of determining the resistance of the resistance section at a defined calibration temperature and a storing step of storing the determined resistance of the resistance section at the defined calibration temperature in a storage. The calibration step comprises acquiring, from the measuring circuit, measurement values of the first voltage and of the second voltage measured at a calibration temperature, and determining the resistance $R_2(T_0)$ of the resistance section at the calibration temperature by

$$R_2(T_0) = \frac{U_2(T_0)}{U_1(T_0)} * R_1(T_0); \qquad\qquad (5)$$

wherein:

$T_0$: is the calibration temperature,
$U_1(T_0)$: is the measured first voltage at the calibration temperature,
$U_2(T_0)$: is the measured second voltage at the calibration temperature, and
$R_1(T_0)$: is the resistance of the first resistance element at the calibration temperature.

Alternatively or in addition to the twelfth aspect or the fourteenth aspect, the method may further comprise a step of determining a second current value of the current flowing through the resistor arrangement based on the second electrical voltage and the second predefined resistance, and a step of comparing the second current value to the first current value in order to check consistency of the determined current values and to detect or diagnose measurement faults and/or "single point faults".

The accompanying drawings are incorporated into the specification and form a part of the specification to illustrate several examples of the present disclosure. These drawings, together with the description serve to explain the principles of the disclosure. The drawings are merely for the purpose of illustrating the preferred and alternative examples of how the disclosure can be made and used, and are not to be construed as limiting the disclosure to only the illustrated and described examples. Furthermore, several aspects of the examples may form-individually or in different combinations-solutions according to the present disclosure. The following described examples thus can be considered either alone or in an arbitrary combination thereof. Further features and advantages will become apparent from the following more particular description of the various examples of the disclosure, as illustrated in the accompanying drawings, in which like references refer to like elements, and wherein:

**FIG. 1** shows a schematic perspective view of an exemplary resistor arrangement;

**FIG. 2** shows a schematic perspective view of the exemplary resistor arrangement with the connected first and second pair of measuring connections;

**FIG. 3** shows a schematic representation of an exemplary current sensor assembly;

**FIG. 4** shows a schematic flow chart of a method for determining a current flowing through the exemplary resistor arrangement;

**Fig. 5** shows a schematic flow chart of a method for determining a temperature of the resistor arrangement.

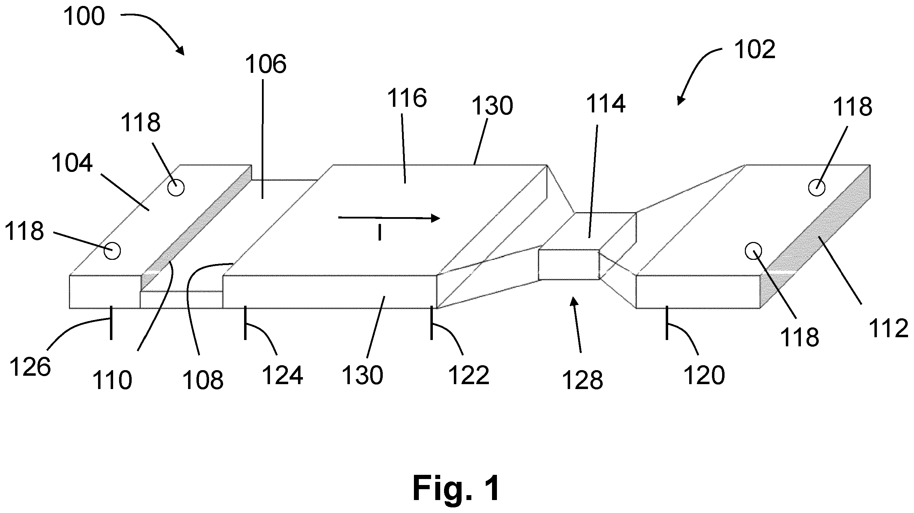

The present disclosure will now be further explained referring to the Figures, and firstly referring to Fig. 1. Fig. 1 shows a resistor arrangement 100, which comprises a first electrically conductive connection element 102, which can be also referred to as a first busbar, and a second electrically conductive connection element 104, which can be also referred to as a second busbar. The first electrically conductive connection element 102 and the second electrically conductive connection element 104 are formed of a first electrically conductive material with a high specific electrical conductivity, like copper or aluminum. A first resistance element 106, which is formed of a first resistance material, which has a lower specific electrical conductivity than the first electrically conductive material, is electrically connected between the first electrically conductive connection element 102 and the second electrically conductive connection element 104.

The first electrically conductive connection element 102, the second electrically conductive connection element 104 and the first resistance element 106 are preferably formed of metallic strips, which are joint at the connection interfaces 108 and 110, which are preferably arranged at opposed ends of the first resistance element 106, by longitudinal seam welding using an electron beam or laser welding method. In this manner, the three elements are arranged in juxtaposition with each other, wherein the first resistance element 106 is connected with a first end to the first electrically conductive connection element 102 and with a second end to the second electrically conductive connection element 104.

The first electrically conductive connection element 102 is an integrally formed element, which comprises three regions, namely a first region, which corresponds to a terminal connection section 112, a second region, which corresponds to a resistance section 114, and a third region, which corresponds to an intermediate connection section 116.

As shown in Fig. 1, the first electrically conductive connection element 102 and the second electrically conductive connection element 104 each comprise at least one contact element 118. The contact elements 118 serve for contacting an external circuit, so as to lead an electrical current I (see the arrow in Fig. 1), which is to be measured in the external circuit, through the resistor arrangement 100. A direction of the electrical current I is arbitrary. The contact elements 118 can for example be formed as cut-outs, which may each be screwed to an external electric component, such as a terminal clamp of a battery or a busbar leading away from the battery. Alternatively, the contact elements 118 can for example be formed as welding or soldering joints, which allow to weld or solder the contact elements 118 to the external electric component. In particular, only the terminal connection section 112 of the first electrically conductive connection element 102 and the second electrically conductive connection element 104 have at least one contact element 118, but not the intermediate connection section 116, which connects the first resistance element 106 with the resistance section 114 of the first electrically conductive connection element 102.

The resistance section 114 is a region of the first electrically conductive connection element 102, which serves as a second resistance element of the resistor arrangement 100, and is arranged between the terminal connection section 112 and the intermediate connection section 116. While a first predefined resistance of the first resistance element 106 typically is in a range of 10 - 50 $\mu$Ohm, a second predefined resistance of the resistance section 114 is typically smaller, i.e. preferably below 10 $\mu$Ohm. However, the second predefined resistance may be designed to have a larger resistance, depending on application scenarios, as long as it is smaller, at least at room temperature, than the first predefined resistance. Thereby, it is in particularly favorable that the resistance value of the resistance section 114 is significantly smaller than the resistance value of the first resistance element 106, so as to impose different measuring ranges for the voltage measurement and improve the independence of the measured values.

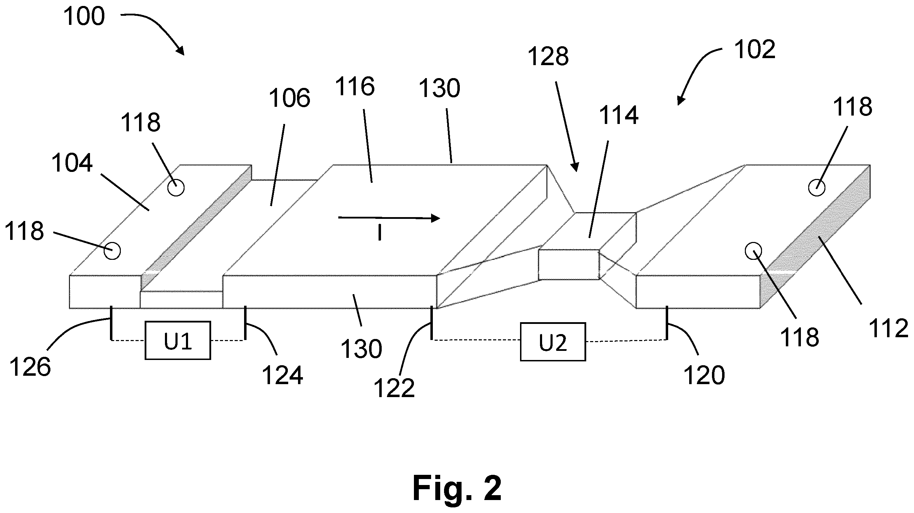

The second predefined resistance is defined as a resistance of a region (i.e. the resistance section 114) of the first electrically conductive connection element 102, which is arranged between a pair of measuring contacts, wherein one measuring contact of the pair of measuring contacts is arranged on the terminal connection section 112 and the other measuring contact of the pair of measuring contacts is arranged on the intermediate connection section 116 as will become apparent in more detail from Fig. 2. Hereby, the second predefined resistance can be a nominal value of the resistance of the resistance section 114, which is includes an uncertainty due to manufacturing tolerances, or can be a calibrated value, which has been individually determined for the resistance section 114 after manufacturing the resistor arrangement 100 at a certain calibration temperature.

For adjusting the second predefined resistance, the resistance section 114 may be shaped with a predefined geometry, and may, for example, include a constriction 128 with a maximum cross section smaller than the minimum cross section of the remaining part of the first electrically conductive connection element 102. The constriction 128 may be formed, for example, by a tapering cut-out provided on at least one of the side surfaces 130 of the first electrically conductive connection element 102, which extend in parallel to the direction of the current I flowing through the resistor arrangement 100. Preferably, the tapering cut-out may be provided on the two side surfaces 130 as shown in Fig. 1. Instead of the tapering cut-out also a rectangle-shaped or circular cut-out is possible. Alternatively or in addition, the constriction 128 may be formed by reducing the thickness in an area of the resistance section 114 to be lower than a minimum thickness of the remaining parts of the first electrically conductive connection element 102, namely the terminal connection section 112 and the intermediate connection section 116. This makes it possible that the resistance section 114 is located at a distance from a circuit board when the resistor arrangement 100 is attached to this circuit board.

FIG. 2 shows that a first pair of measuring contacts 124 and 126 for measuring a first electrical voltage $U_1$ dropping across the first resistance element 106 and a second pair of measuring contacts 120 and 122 for measuring a second electrical voltage $U_2$ dropping across the resistance section 114 are provided, with the measuring contact 124 from the first pair of measuring contacts and the measuring contact 122 from the second pair of measuring connections being assigned to the intermediate connection section 116. With this measurement configuration, the resistance section 114 is defined as the region of the first electrically conductive connection element, which extends between the measuring contacts 120 and 122, so that the second predefined resistance is defined as the resistance measurable between the measuring contacts 120 and 122. Here, the voltage measuring contacts 120, 122, 124, and 126 are shown schematically because they may be formed by any suitable contacting technique known in the art.

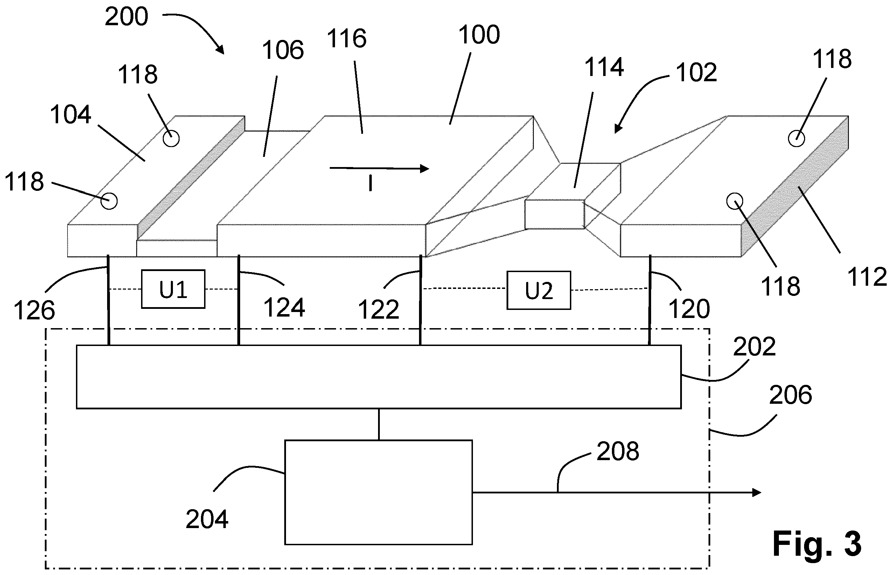

As shown in Fig. 3, the measuring arrangement illustrated in Fig. 2 can be integrated into a current sensor assembly 200, which comprises, in addition to the resistor arrangement 100, a first voltage tap for measuring the first electrical voltage $U_1$, and a second voltage tap for measuring the second electrical voltage $U_2$ and a measuring circuit 202 for measuring the first electrical voltage $U_1$ and the second electrical voltage $U_2$. The measuring circuit 202 may for example be a high voltage analog-to-digital converter (HVADC), which serves as an analog-to-digital converter that converts the two analog measurement voltages output by the first voltage tap and the second voltage tap into two digital measurement voltage signals. The HVADC may comprise dedicated electronics for performing the individual voltage detections in parallel or may comprise electronics for performing the individual voltage detections in a serial order. Advantageously, however, the electronics of the measuring circuit 202 are set up in such a way that the measurement of the first electrical voltage $U_1$ and the measurement of the second electrical voltage $U_2$ can take place independently of one another, so that a failure of one of the two measuring chains can be recognized by comparing the two measurements.

The current sensor assembly 200 as shown in Fig.3 also comprise a processing circuit 204, which may be provided in form of a microcontroller or integrated circuit. The measuring circuit 202 and the processing circuit 204 may be mounted on a component carrier, like a (printed) circuit board, to form an assembled circuit 206 as schematically shown in Fig. 3 by the dash-dotted line. The assembled circuit may be attached to the resistor arrangement 100.

Alternatively, it is also possible that electronics components of the assembled circuit, especially the processing circuit 204 (and the storage), are provided by an external controller, like a central controller of a BMS or a vehicle ECU. In such a configuration, the external controller executes the function of a current determination device, which is configured to carry out the functions and methods, which are described in the following for the processing circuit 204, for example by running a computer program, which is stored in a storage of the external controller and comprises instructions which, when the program is executed by the external controller, cause the external controller to carry out the corresponding methods.

The processing circuit 204 is configured to acquire measurement values from the measuring circuit 202 by digital communication, and to process the measurement signals in order to generate an output signal 208 and to transmit the output signal 208 to an external controller like a BMS or vehicle ECU. The output signal 208 can for example indicate a value of the current I flowing through the resistor arrangement 100, or a value of the temperature T of the resistor arrangement 100 or a part of the resistor arrangement 100. Furthermore, the output signal 208 can be a warning signal, which indicates whether at least one of the determined temperature value and the determined current value is outside of a safe operating range.

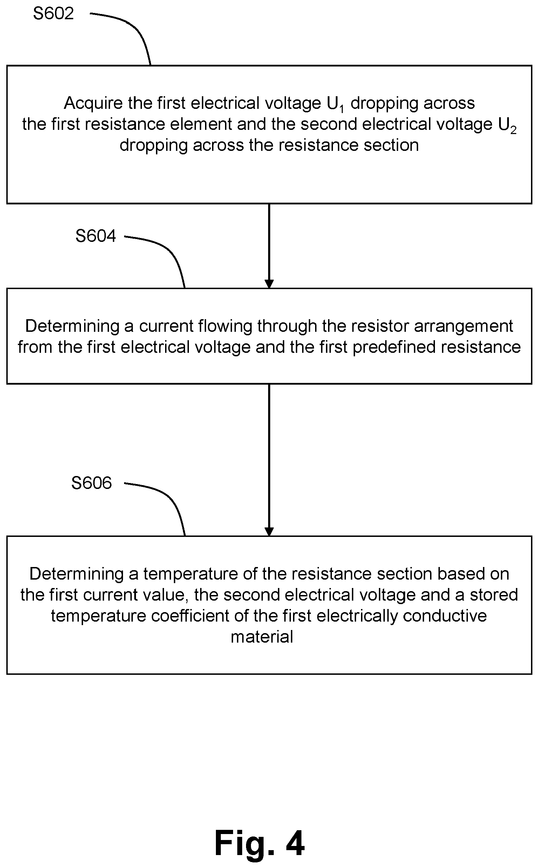

Fig. 4 shows a schematic flow chart of a method, which may be performed by the processing circuit 204, for determining the current I flowing through the exemplary resistor arrangement 100. In a first step S602, the processing circuit 204 receives a first input signal from the measuring circuit 202 indicating information on a measurement value of the first electrical voltage $U_1$ dropping across the first resistance element 106. The first input signal can be received at predetermined time intervals, like once per $1\mu s$, once per 1ms, or similar. Alternatively, the first input signal can be received in response to an instruction of the processing circuit 204 for the measuring circuit 202 to transmit the information on the measurement value of the first electrical voltage.

In addition, the processing circuit 204 receives a second input signal from the measuring circuit 202 indicating information on a measurement value of the second electrical voltage $U_2$ dropping across the resistance section 114. Again, the second input signal can be received at predetermined time intervals like once per $1\mu s$, once per 1ms, or similar. Alternatively, the second input signal can be received in response to an instruction of the processing circuit 204 for the measuring circuit 202 to transmit the information on the measurement value of the second electrical voltage. Notably, a sequence of receiving the first input signal and the second input signal may be switched, or both steps may be performed in parallel.

In a second step S604, the processing circuit 204 determines a first current value $I_1$ of the current I from the acquired first voltage $U_1$ and the first predefined resistance of the first resistance element 106 by using the first part of equation (4) explained above

$$I_1 = \frac{U_1}{R_1} \tag{4}$$

Optionally, in order to check the consistency of the determined current values and to detect or diagnose measurement faults and/or "single point faults", the processing circuit 204 may also determine a second current value $I_2$ of the current I from the acquired second voltage $U_2$ and the second predefined resistance of the resistance section 114 by using the second part of the above explained equation (4)

$$I_2 = \frac{U_2}{R_2} \tag{4}$$

The processing circuit 204 then may compare the first current value and the second current value to each other, in order to assess the reliability of the measurement values.

In a third step S606, the processing circuit 204 uses the acquired second voltage $U_2$ to determine the temperature of the resistance section 114 during the voltage measurement. For this purpose, the processing circuit 204 uses the fact that the first electrically conductive material, of which the resistance section 114 as a part of the first electrically conductive connection element 102 is formed, has a linear temperature coefficient $\alpha$ (e.g. 0,0039 1/K for copper or 0,004 1/K for aluminum) in the operating temperature range of the resistor arrangement 100. By referring to a stored value of the temperature coefficient $\alpha$ of the first electrically conductive material, for example stored in a storage of the assembled circuit 206, the processing circuit 204 determines the actual temperature T of the resistance section 114 by equation (2) explained above:

$$T = T_0 + \left[\frac{R_2(T) - R_2(T_0)}{\alpha * R_2(T_0)}\right] \tag{2}$$

wherein:

$\alpha$:     is the temperature coefficient of the first electrically conductive material (e.g. 0.0039 1/K for copper);

T:     is the actual temperature of the resistance section 114;

$T_0$:     is the temperature at which a calibration step of the resistance of the resistance section 114 is performed (e. g. 20 °C);

$R_2(T_0)$:     is the resistance of the resistance section 114 determined at the calibration temperature.

For determining the resistance $R_2(T)$ of the resistance section 114 at the temperature T, the processing circuit 204 can use equation (3) explained above

$$R_2(T) = \frac{U_2}{I} = \frac{U_2 * R_1(T)}{U_1} \tag{3}$$

wherein:

$U_2$:     is the measured second voltage;

$U_1$:     is the measured first voltage; and

$R_1(T)$:     is the resistance of the first resistance element 106 determined at the temperature T.

The temperature T used in equation (3) can be estimated by the processing circuit 204 or can be acquired from an external temperature sensor attached to the resistor arrangement as will be described below.

Since the resistance section 114 is directly thermally coupled to the first resistance element 106 by the intermediate connection section 116, it can be assumed that the temperature of the first resistance element 106 corresponds to the determined temperature of the resistance section 114, so that the determined temperature of the resistance section 114 can be used to perform an accurate TCR (temperature coefficient ratio) correction of the resistance of the first resistance element 106 and accordingly enhance the accuracy of the determination of the first current value. Accordingly, the specific configuration of the resistor arrangement 100 allows for a determination of the temperature of the first resistance element 106, i.e. a temperature of the resistor arrangement 100 (as the determined temperature of the resistance section 114) without the need for sensing the temperature with an external temperature sensor. Since the sampling times for measuring the second voltage $U_2$, from which the temperature T is determined by the processing circuit 204, is smaller than the sampling time of usual external temperature sensors, the above described temperature determination method provides even higher accuracies for the temperature determination, when the resistor arrangement 100 is used during dynamic load profiles, i.e. rapid changes in load and heating.

However, it is also possible to additionally sense the temperature of the first resistor element 106 with an external temperature sensor and to compare the additionally sensed temperature to the determined temperature in order to assess the reliability of the temperature determination. For example, a high deviation of the determined temperature from the additionally sensed temperature may hint to a significant drift of the (nominal) resistance of the resistance section 114 and can indicate that a calibration measurement of the resistance of the resistance section 114 should be performed. Such a consistency check is not possible with regular resistor arrangements, since the temperature dependency of the temperature coefficient of the first resistance material, of which the resistance elements, are usually formed is too small and follows a non-linear behavior.

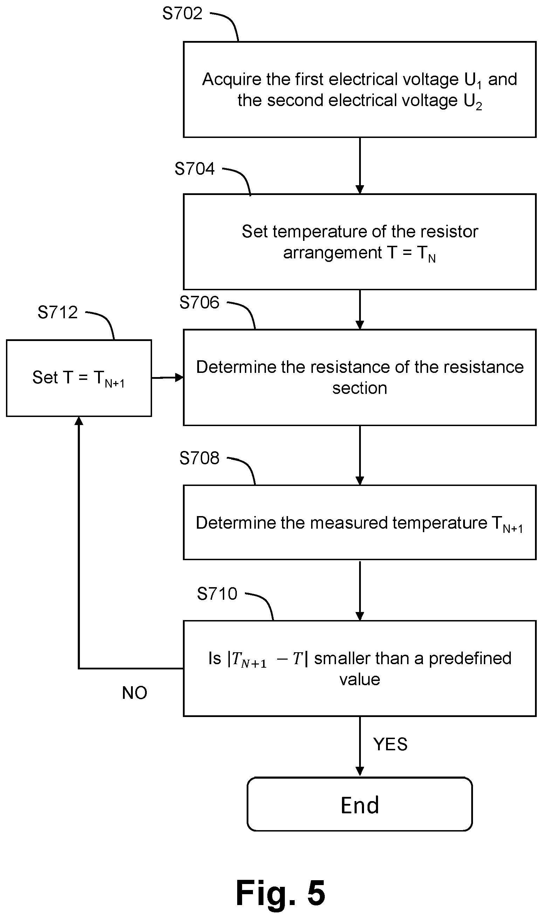

In order to enhance the accuracy of the temperature detection, the processing circuit 204 is configured to iteratively determine the temperature of the resistance section 114, until the temperature value converges. Fig. 5 shows a schematic flow chart of a method for iteratively determining a temperature of the resistance section 114 performed by the processing circuit 204.

In a first step S702, the processing circuit 204 acquires the first electrical voltage $U_1$ and the second electrical voltage $U_2$ from the measuring circuit 202 in analogy to step S602 explained above. In a second step 704, the processing circuit 204 estimates a starting temperature $T_N$ and assumes the temperature of the resistance section 114 and of the first resistance element 106 to be $T_N$. For example, the staring temperature $T_N$ can be a temperature, additionally sensed with an external temperature sensor attached to the resistor arrangement 100, but can also be estimated by the processing circuit 204.

Next, in step S706, the processing circuit 204 determines the resistance $R_2(T_N)$ of the resistance section 114 at the temperature $T_N$, by equation (3) explained above:

$$R_2(T_N) = \frac{U_2}{I} = \frac{U_2 * R_1(T_N)}{U_1} \tag{3}$$

wherein $R_1(T_N)$ is the resistance of the first resistance element 106 determined at the start temperature $T_N$.

Using the resistance $R_2(T_N)$ of the resistance section 114, the processing circuit 204 determines in step S708 a measured temperature $T_{N+1}$ of the resistance section 114, by using equation (2) explained above as

$$T_{N+1} = T_0 + \left[ \frac{R_2(T_N) - R_2(T_0)}{\alpha * R_2(T_0)} \right]. \tag{2}$$

The processing circuit 204 then evaluates in an evaluating step S710, whether the measured temperature $T_{N+1}$ of the resistance section 114 converges, by determining whether a difference between the measured temperature $T_{N+1}$ and the starting temperature $T_N$ is smaller than a predetermined convergence limit. In other words, in step S710, it is determined whether $\Delta T = |T_{N+1} - T_N|$ is smaller than a predetermined convergence limit. If the processing circuit 204 determines that $\Delta T$ is smaller than the predetermined convergence limit (YES in step S710), the processing circuit 204 sets $T_{N+1}$ as the determined temperature of the resistance section 114 and ends the method. If the processing circuit 204 determines that $\Delta T$ is not smaller than the predetermined convergence limit (NO in step S710), the processing circuit 204 sets the measured temperature $T_{N+1}$ as the new starting temperature (S712) and repeats steps S706 - S710 with the new starting temperature $T_{N+1}$.

Furthermore, in order to enhance the accuracy of the temperature determination, the processing circuit 204 may perform a calibration of the resistance of the resistance section 114 (i.e. the second predefined resistance) and store the parameters gained from the calibration measurement in the storage of the assembled circuit 206. The calibration of the resistance of the resistance section 114, can be performed before the first use of the resistor arrangement 100, or can be performed regularly or in consequence to determining that the calibration becomes necessary. For calibrating the resistance of the resistance section 114, the processing circuit 204 may acquire, from the measuring circuit 202, the measurement values of the first voltage $U_1$ and of the second voltage $U_2$ measured at a defined calibration temperature $T_0$. The processing circuit 204 then determines the resistance $R_2(T_0)$ of the resistance section 114 at the calibration temperature by

$$R_2(T_0) = \frac{U_2(T_0)}{U_1(T_0)} * R_1(T_0); \tag{5}$$

wherein:

$T_0$: is the calibration temperature,

$U_1(T_0)$: is the measured first voltage at the calibration temperature,

$U_2(T_0)$: is the measured second voltage at the calibration temperature, and

$R_1(T_0)$: is the resistance of the first resistance element at the calibration temperature.

The functionalities of each component of the assembled circuit 206 may be realized by software, hardware, or software in cooperation with hardware. Furthermore, each circuit of the assembled circuit 206 can be realized as a dedicated integrated circuit and the dedicated integrated circuits are assembled to form the assembled circuit. Alternatively, the functionalities of each circuit may be integrated into a common integrated circuit, which forms the assembled circuit. Alternatively, one or more circuits of the assembled circuit may be realized by using general-purpose processors, special-purpose processors, or FPGAs (Field Programmable Gate Array) that can be programmed.

At this point, it should be also noted that, while the resistor arrangement 100 has been exemplarily described to have a single resistance element 106 and a single resistance section 114, a number of resistance elements is not restricted to one. Instead, the same advantages can be achieved when integrating the resistance section 114 into a resistor arrangement with more than one resistance element. Further, it is also possible to integrate more than one resistance section in the resistor arrangement 100, for example respectively one in the different bus-bars (connection elements) 102 and 104 of the resistor arrangement 100.

## REFERENCE NUMERALS

| 100 | resistor arrangement |
|---|---|
| 102, 104 | electrically conductive connection elements |
| 106 | resistance element |
| 108, 110 | connection interfaces |
| 112 | terminal connection section |
| 114 | resistance section |
| 116 | intermediate connection section |
| 118 | contact elements |
| 120, 122, 124, 126 | measuring contacts |
| 128 | constriction |
| 130 | side surfaces |
| 200 | current sensor assembly |
| 202 | measuring circuit |
| 204 | processing circuit |
| 206 | assembled circuit |
| 208 | output signal |

## Claims

1. Current sensor assembly (200), comprising

    a resistor arrangement (100) comprising:

       a first electrically conductive connection element (102) and a second electrically conductive connection element (104), which are formed of a first electrically conductive material having a first specific electrical conductivity;
       a first resistance element (106) formed of a first resistance material having a second specific electrical conductivity, which is lower than the first specific electrical conductivity,
       wherein the first resistance element (106) is connected with a first end to the first electrically conductive connection element (102) and with a second end to the second electrically conductive connection element (104);
       wherein the first electrically conductive connection element (102) comprises

          a terminal connection section (112), which is configured to be electrically connected to an external conductor of an electrical circuit;

an intermediate connection section (116), which is connected with the first end of the resistance element; and

a resistance section (114), which is arranged in between the terminal connection section (112) and the intermediate section (116); and

wherein the first resistance element (106) has a first predefined resistance, and wherein the resistance section (114) of the first electrically conductive connection element has a second predefined resistance, wherein the current sensor assembly (200) further comprises

a first voltage tap for measuring a first electrical voltage ($U_1$) dropping across the first resistance element (106);

a second voltage tap for measuring a second electrical voltage ($U_2$) dropping across the resistance section (114);

a measuring circuit (202), which is configured to measure the first electrical voltage ($U_1$) and the second electrical voltage ($U_2$);

a storage, which is configured to store a temperature coefficient of the first electrically conductive material, and

a processing circuit (204), which is configured to determine

• a first current value of a current (I) flowing through the resistor arrangement (100) based on the first electrical voltage ($U_1$) and the first predefined resistance, and

• a temperature of the resistance section (114) of the first electrically conductive connection element (102) based on the first current value, the second electrical voltage ($U_2$) and the stored temperature coefficient of the first electrically conductive material,

**characterized in that**

the measuring circuit (202) is configured to perform the measurement of the first electrical voltage ($U_1$) and of the second electrical voltage ($U_2$) independently from one another; and

the processing circuit (204) is configured to iteratively repeat the determination of the temperature of the resistance section (114) until a difference between the determined temperature and a starting temperature, which is set as an assumed temperature of the resistance section (114) for the temperature determination, is smaller than a predetermined convergence limit.

2. The current sensor assembly (200) according to claim 1, wherein the second predefined resistance is smaller than the first predefined resistance.

3. The current sensor assembly (200) according to one of claims 1 or 2, wherein the resistor arrangement (100) further comprises a first measuring contact pair (124, 126) for measuring a first electrical voltage ($U_1$) dropping across the first resistance element (106) and a second measuring contact pair (120, 122) for measuring a second electrical voltage ($U_2$) dropping across the resistance section (114) of the first electrically conductive connection element (102), wherein a first measuring contact (124) from the first measuring contact pair and a second measuring contact (122) from the second measuring contact pair are arranged on the intermediate connection section (116) of the first electrically conductive connection element (102).

4. The current sensor assembly (200) according to one of the preceding claims, wherein the resistance section (114) includes a constriction (128), which has a predetermined geometrical shape.

5. The current sensor assembly (200) according to one of the preceding claims, wherein the first electrically conductive connection element (102) is formed in such a way that a minimum thickness of the resistance section (114) is smaller than a minimum thickness of the terminal connection section (112) and a minimum thickness of the intermediate connection section (116) and/or that a minimum width of the resistance section (114) is smaller than a minimum width of the terminal connection section (112) and a minimum width of the intermediate connection section (116).

6. The current sensor assembly (200) according to any of the preceding claims, wherein only the terminal connection section (112) of the first electrically conductive connection element (102) and the second electrically conductive connection element (104) comprise connection means (118) for integrating the resistor arrangement into an electric circuit.

7. The current sensor assembly (200) according to one of claims 1 to 6, further comprising a temperature sensor attached to the resistor arrangement (100), which is configured to measure a second temperature of the resistor arrangement (100), wherein the processing circuit (204) is further configured to compare the determined temperature of the resistance section (114) to the second temperature which is measured with the temperature sensor.

8. The current sensor assembly (200) according to one of claims 1 to 7, wherein the processing circuit (204) is further configured to determine a second current value of the current (I) flowing through the resistor arrangement (100) based on the second electrical voltage ($U_2$) and the second predefined resistance, and to compare the second current value to the first current value.

9. A method for determining a temperature of a resistor arrangement (100), the resistor arrangement (100) comprising:

a first electrically conductive connection element (102) and a second electrically conductive connection element (104), which are formed of a first electrically conductive material having a first specific electrical conductivity;
a first resistance element (106) formed of a first resistance material having a second specific electrical conductivity, which is lower than the first specific electrical conductivity,
wherein the first resistance element (106) is connected with a first end to the first electrically conductive connection element (102) and with a second end to the second electrically conductive connection element (104);
wherein the first electrically conductive connection element (102) comprises

a terminal connection section (112), which is configured to be electrically connected to an external conductor of an electrical circuit;
an intermediate connection section (116), which is connected with the first end of the resistance element; and
a resistance section (114), which is arranged in between the terminal connection section (112) and the intermediate section (116); and

wherein the first resistance element (106) has a first predefined resistance, and wherein the resistance section (114) of the first electrically conductive connection element has a second predefined resistance; and

the method comprising the steps of:

acquiring (S702), from a measuring circuit (202), measurement values of a measurement of a first electrical voltage ($U_1$) dropping across the first resistance element (106) and of a measurement of a second electrical voltage ($U_2$) dropping across the resistance section (114) of the first electrically conductive connection element (102);
determining (S704) a first current value of a current (I) flowing through the resistor arrangement based on the first electrical voltage ($U_1$) and the first predefined resistance; and
determining (S706) a temperature of the resistance section (114) of the first electrically conductive connection element (102) based on the first current value, the second electrical voltage ($U_2$) and a stored temperature coefficient of the first electrically conductive material
**characterized in that**
the measurement of the first electrical voltage ($U_1$) and of the second electrical voltage ($U_2$) are performed independently from one another, and
the determination of the temperature of the resistance section (114) is iteratively repeated until a difference between the determined temperature and a starting temperature, which is set as an assumed temperature of the resistance section (114) for the temperature determination, is smaller than a predetermined convergence limit.

10. The method according to claim 9, further comprising a step of comparing the determined temperature of the resistance section (114) to a second temperature, which is measured with a temperature sensor attached to the resistor arrangement (100).

11. The method according to one of claims 9 or 10, further comprising a calibration step of determining the resistance of the resistance section (114) at a defined calibration temperature and a storing step of storing the determined resistance of the resistance section (114) at the defined calibration temperature in a storage, wherein the calibration step comprises:

acquiring, from the measuring circuit (202), measurement values of the first voltage ($U_1$) and of the second voltage ($U_2$) measured at a calibration temperature;
determining the resistance $R_2(T_0)$ of the resistance section (114) at the calibration temperature by

$$R_2(T_0) = \frac{U_2(T_0)}{U_1(T_0)} * R_1(T_0);$$

wherein $R_2(T_0)$ is the resistance of the resistance section (114) at the calibration temperature; $T_0$ is the calibration temperature, $U_1(T_0)$ is the measured first voltage at the calibration temperature, $U_2(T_0)$ is the measured second voltage at the calibration temperature, and $R_1(T_0)$ is the resistance of the first resistance element at the calibration temperature.

**Patentansprüche**

1.  Stromsensorbaugruppe (200), umfassend

    eine Widerstandsanordnung (100), die Folgendes umfasst:

    ein erstes elektrisch leitfähiges Verbindungselement (102) und ein zweites elektrisch leitfähiges Verbindungselement (104), die aus einem ersten elektrisch leitfähigen Material mit einer ersten spezifischen elektrischen Leitfähigkeit gebildet sind;
    ein erstes Widerstandselement (106), das aus einem ersten Widerstandsmaterial mit einer zweiten spezifischen elektrischen Leitfähigkeit gebildet ist, die niedriger ist als die erste spezifische elektrische Leitfähigkeit,
    wobei das erste Widerstandselement (106) mit einem ersten Ende mit dem ersten elektrisch leitfähigen Verbindungselement (102) und mit einem zweiten Ende mit dem zweiten elektrisch leitfähigen Verbindungselement (104) verbunden ist;
    wobei das erste elektrisch leitfähige Verbindungselement (102) umfasst

    einen Anschlussverbindungsabschnitt (112), der so konfiguriert ist, dass er elektrisch mit einem externen Leiter eines Stromkreises verbunden werden kann;
    einen Zwischenverbindungsabschnitt (116), der mit dem ersten Ende des Widerstandselements verbunden ist; und
    einen Widerstandsabschnitt (114), der zwischen dem Anschlussverbindungsabschnitt (112) und dem Zwischenabschnitt (116) angeordnet ist; und

    wobei das erste Widerstandselement (106) einen ersten vordefinierten Widerstand aufweist und wobei der Widerstandsabschnitt (114) des ersten elektrisch leitfähigen Verbindungselements einen zweiten vordefinierten Widerstand aufweist,
    wobei die Stromsensorbaugruppe (200) ferner umfasst
    einen ersten Spannungsabgriff zum Messen einer ersten elektrischen Spannung ($U_1$), die über dem ersten Widerstandselement (106) abfällt;
    einen zweiten Spannungsabgriff zum Messen einer zweiten elektrischen Spannung ($U_2$), die über dem Widerstandsabschnitt (114) abfällt;
    eine Messschaltung (202), die so konfiguriert ist, dass sie die erste elektrische Spannung ($U_1$) und die zweite elektrische Spannung ($U_2$) misst;
    einen Speicher, der so konfiguriert ist, dass er einen Temperaturkoeffizienten des ersten elektrisch leitfähigen Materials speichert, und
    eine Verarbeitungsschaltung (204), die so konfiguriert ist, dass sie
    • einen ersten Stromwert eines durch die Widerstandsanordnung (100) fließenden Stroms (I) auf der Grundlage der ersten elektrischen Spannung ($U_1$) und des ersten vordefinierten Widerstands bestimmt, und
    • eine Temperatur des Widerstandsabschnitts (114) des ersten elektrisch leitfähigen Verbindungselements (102) auf der Grundlage des ersten Stromwerts, der zweiten elektrischen Spannung ($U_2$) und des gespeicherten Temperaturkoeffizienten des ersten elektrisch leitfähigen Materials bestimmt,

    **dadurch gekennzeichnet, dass**
    die Messschaltung (202) so konfiguriert ist, dass sie die Messung der ersten elektrischen Spannung ($U_1$) und der zweiten elektrischen Spannung ($U_2$) unabhängig voneinander durchführt; und
    die Verarbeitungsschaltung (204) so konfiguriert ist, dass sie die Bestimmung der Temperatur des Widerstandsabschnitts (114) iterativ wiederholt, bis eine Differenz zwischen der bestimmten Temperatur und einer Starttemperatur, die als angenommene Temperatur des Widerstandsabschnitts (114) für die Temperaturbestimmung festgelegt ist, kleiner als eine vorbestimmte Konvergenzgrenze ist.

2. Die Stromsensorbaugruppe (200) gemäß Anspruch 1, wobei der zweite vordefinierte Widerstand kleiner ist als der erste vordefinierte Widerstand.

3. Die Stromsensorbaugruppe (200) gemäß einem der Ansprüche 1 oder 2, wobei die Widerstandsanordnung (100) ferner ein erstes Messkontaktpaar (124, 126) zum Messen einer ersten elektrischen Spannung ($U_1$), die über dem ersten Widerstandselement (106) abfällt, und ein zweites Messkontaktpaar (120, 122) zum Messen einer zweiten elektrischen Spannung ($U_2$), die über dem Widerstandsabschnitt (114) des ersten elektrisch leitenden Verbindungselements (102) abfällt, umfasst, wobei ein erster Messkontakt (124) aus dem ersten Messkontaktpaar und ein zweiter Messkontakt (122) aus dem zweiten Messkontaktpaar auf dem Zwischenverbindungsabschnitt (116) des ersten elektrisch leitenden Verbindungselements (102) angeordnet sind.

4. Die Stromsensorbaugruppe (200) gemäß einem der vorherigen Ansprüche, wobei der Widerstandsabschnitt (114) eine Verengung (128) aufweist, die eine vorbestimmte geometrische Form hat.

5. Die Stromsensorbaugruppe (200) gemäß einem der vorherigen Ansprüche, wobei das erste elektrisch leitende Verbindungselement (102) so ausgebildet ist, dass eine Mindestdicke des Widerstandsabschnitts (114) kleiner ist als eine Mindestdicke des Anschlussverbindungsabschnitts (112) und eine Mindestdicke des Zwischenverbindungsabschnitts (116) und/oder dass eine Mindestbreite des Widerstandsabschnitts (114) kleiner ist als eine Mindestbreite des Anschlussverbindungsabschnitts (112) und eine Mindestbreite des Zwischenverbindungsabschnitts (116).

6. Die Stromsensorbaugruppe (200) gemäß einem der vorherigen Ansprüche, wobei nur der Anschlussverbindungsabschnitt (112) des ersten elektrisch leitenden Verbindungselements (102) und das zweite elektrisch leitende Verbindungselement (104) Verbindungsmittel (118) zum Integrieren der Widerstandsanordnung in einen Stromkreis umfassen.

7. Die Stromsensorbaugruppe (200) gemäß einem der Ansprüche 1 bis 6, die ferner einen an der Widerstandsanordnung (100) angebrachten Temperatursensor umfasst, der so konfiguriert ist, dass er eine zweite Temperatur der Widerstandsanordnung (100) misst, wobei die Verarbeitungsschaltung (204) ferner so konfiguriert ist, dass sie die ermittelte Temperatur des Widerstandsabschnitts (114) mit der zweiten Temperatur vergleicht, die mit dem Temperatursensor gemessen wird.

8. Die Stromsensorbaugruppe (200) gemäß einem der Ansprüche 1 bis 7, wobei die Verarbeitungsschaltung (204) ferner so konfiguriert ist, dass sie einen zweiten Stromwert des durch die Widerstandsanordnung (100) fließenden Stroms (I) auf der Grundlage der zweiten elektrischen Spannung ($U_2$) und des zweiten vordefinierten Widerstands bestimmt und den zweiten Stromwert mit dem ersten Stromwert vergleicht.

9. Verfahren zum Bestimmen einer Temperatur einer Widerstandsanordnung (100), wobei die Widerstandsanordnung (100) umfasst:

ein erstes elektrisch leitfähiges Verbindungselement (102) und ein zweites elektrisch leitfähiges Verbindungselement (104), die aus einem ersten elektrisch leitfähigen Material mit einer ersten spezifischen elektrischen Leitfähigkeit gebildet sind;
ein erstes Widerstandselement (106), das aus einem ersten Widerstandsmaterial mit einer zweiten spezifischen elektrischen Leitfähigkeit gebildet ist, die niedriger ist als die erste spezifische elektrische Leitfähigkeit,
wobei das erste Widerstandselement (106) mit einem ersten Ende mit dem ersten elektrisch leitfähigen Verbindungselement (102) und mit einem zweiten Ende mit dem zweiten elektrisch leitfähigen Verbindungselement (104) verbunden ist;
wobei das erste elektrisch leitfähige Verbindungselement (102) umfasst

einen Anschlussverbindungsabschnitt (112), der so konfiguriert ist, dass er elektrisch mit einem externen Leiter eines Stromkreises verbunden ist;
einen Zwischenverbindungsabschnitt (116), der mit dem ersten Ende des Widerstandselements verbunden ist; und
einen Widerstandsabschnitt (114), der zwischen dem Anschlussverbindungsabschnitt (112) und dem Zwischenabschnitt (116) angeordnet ist; und

wobei das erste Widerstandselement (106) einen ersten vordefinierten Widerstand aufweist und wobei der Widerstandsabschnitt (114) des ersten elektrisch leitenden Verbindungselements einen zweiten vordefinierten Widerstand aufweist; und

wobei das Verfahren die folgenden Schritte umfasst:

Erfassen (S702), durch eine Messschaltung (202), von Messwerten einer Messung einer ersten elektrischen Spannung ($U_1$), die über dem ersten Widerstandselement (106) abfällt, und einer Messung einer zweiten elektrischen Spannung ($U_2$), die über dem Widerstandsabschnitt (114) des ersten elektrisch leitfähigen Verbindungselements (102) abfällt;
Bestimmen (S704) eines ersten Stromwerts eines durch die Widerstandsanordnung fließenden Stroms (I) auf der Grundlage der ersten elektrischen Spannung ($U_1$) und des ersten vordefinierten Widerstands; und
Bestimmen (S706) einer Temperatur des Widerstandsabschnitts (114) des ersten elektrisch leitfähigen Verbindungselements (102) auf der Grundlage des ersten Stromwerts, der zweiten elektrischen Spannung ($U_2$) und eines gespeicherten Temperaturkoeffizienten des ersten elektrisch leitfähigen Materials;
**dadurch gekennzeichnet, dass**
die Messung der ersten elektrischen Spannung ($U_1$) und der zweiten elektrischen Spannung ($U_2$) unabhängig voneinander durchgeführt werden, und
die Bestimmung der Temperatur des Widerstandsabschnitts (114) iterativ wiederholt wird, bis eine Differenz zwischen der bestimmten Temperatur und einer Starttemperatur, die als angenommene Temperatur des Widerstandsabschnitts (114) für die Temperaturbestimmung festgelegt ist, kleiner als eine vorbestimmte Konvergenzgrenze ist.

10. Das Verfahren gemäß Anspruch 9, das ferner einen Schritt des Vergleichens der ermittelten Temperatur des Widerstandsabschnitts (114) mit einer zweiten Temperatur umfasst, die mit einem an der Widerstandsanordnung (100) angebrachten Temperatursensor gemessen wird.

11. Das Verfahren gemäß einem der Ansprüche 9 oder 10, das ferner einen Kalibrierungsschritt zum Bestimmen des Widerstands des Widerstandsabschnitts (114) bei einer definierten Kalibrierungstemperatur und einen Speicherschritt zum Speichern des bestimmten Widerstands des Widerstandsabschnitts (114) bei der definierten Kalibrierungstemperatur in einem Speicher umfasst, wobei der Kalibrierungsschritt umfasst:

Erfassen, durch die Messschaltung (202), von Messwerten der ersten Spannung ($U_1$) und der zweiten Spannung ($U_2$), die bei einer Kalibriertemperatur gemessen wurden;
Bestimmen des Widerstands $R_2 (T_0)$ des Widerstandsabschnitts (114) bei der Kalibriertemperatur durch

$$R_2(T_0) = \frac{U_2(T_0)}{U_1(T_0)} * R_1(T_0);$$

wobei $R_2 (T_0)$ der Widerstand des Widerstandsabschnitts (114) bei der Kalibriertemperatur ist; $T_0$ die Kalibriertemperatur ist, $U_1 (T_0)$ die gemessene erste Spannung bei der Kalibriertemperatur ist, $U_2 (T_0)$ die gemessene zweite Spannung bei der Kalibriertemperatur ist, und $R_1 (T_0)$ der Widerstand des ersten Widerstandselements bei der Kalibriertemperatur ist.

**Revendications**

1. Ensemble de capteurs de courant (200), comprenant :

un agencement de résistances (100) comprenant :

un premier élément de connexion électriquement conducteur (102) et un deuxième élément de connexion électriquement conducteur (104), lesquels sont formés d'un premier matériau électriquement conducteur présentant une première conductivité électrique spécifique ;
un premier élément de résistance (106) formé d'un premier matériau de résistance présentant une deuxième conductivité électrique spécifique, qui est inférieure à la première conductivité électrique spécifique,
dans lequel le premier élément de résistance (106) est connecté, avec une première extrémité, au premier élément de connexion électriquement conducteur (102), et, avec une deuxième extrémité, au deuxième élément de connexion électriquement conducteur (104) ;
dans lequel le premier élément de connexion électriquement conducteur (102) comprend :

une section de connexion terminale (112), qui est configurée pour être électriquement connectée à un conducteur externe d'un circuit électrique ;
une section de connexion intermédiaire (116), qui est connectée à la première extrémité de l'élément de résistance ; et
une section de résistance (114), qui est agencée entre la section de connexion terminale (112) et la section intermédiaire (116) ; et

dans lequel le premier élément de résistance (106) présente une première résistance prédéfinie, et dans lequel la section de résistance (114) du premier élément de connexion électriquement conducteur présente une deuxième résistance prédéfinie,
dans lequel l'ensemble de capteurs de courant (200) comprend en outre
une première prise de tension pour mesurer une première tension électrique ($U_1$) apparaissant aux bornes du premier élément de résistance (106) ;
une deuxième prise de tension pour mesurer une deuxième tension électrique ($U_2$) apparaissant aux bornes de la section de résistance (114) ;
un circuit de mesure (202), qui est configuré pour mesurer la première tension électrique ($U_1$) et la deuxième tension électrique ($U_2$) ;
une mémoire, qui est configurée pour stocker un coefficient de température du premier matériau électriquement conducteur ; et
un circuit de traitement (204), qui est configuré pour déterminer

• une première valeur de courant d'un courant (I) circulant dans l'agencement de résistances (100) sur la base de la première tension électrique ($U_1$) et de la première résistance prédéfinie, et
• une température de la section de résistance (114) du premier élément de connexion électriquement conducteur (102) sur la base de la première valeur de courant, de la deuxième tension électrique ($U_2$) et du coefficient de température stocké du premier matériau électriquement conducteur,

**caractérisé en ce que**
le circuit de mesure (202) est configuré pour effectuer la mesure de la première tension électrique ($U_1$) et de la deuxième tension électrique ($U_2$) de manière indépendante l'une de l'autre ; et
le circuit de traitement (204) est configuré pour répéter de manière itérative la détermination de la température de la section de résistance (114) jusqu'à ce qu'une différence entre la température déterminée et une température de départ, qui est définie comme température supposée de la section de résistance (114) pour la détermination de température, soit inférieure à une limite de convergence prédéterminée.

2. Ensemble de capteurs de courant (200) selon la revendication 1, dans lequel la deuxième résistance prédéfinie est inférieure à la première résistance prédéfinie.

3. Ensemble de capteurs de courant (200) selon l'une des revendications 1 ou 2, dans lequel l'agencement de résistances (100) comprend en outre une première paire de contacts de mesure (124, 126) pour mesurer une première tension électrique ($U_1$) apparaissant aux bornes du premier élément de résistance (106), et une deuxième paire de contacts de mesure (120, 122) pour mesurer une deuxième tension électrique ($U_2$) apparaissant aux bornes de la section de résistance (114) du premier élément de connexion électriquement conducteur (102), dans lequel un premier contact de mesure (124) de la première paire de contacts de mesure, et un deuxième contact de mesure (122) de la deuxième paire de contacts de mesure sont agencés sur la section de connexion intermédiaire (116) du premier élément de connexion électriquement conducteur (102).

4. Ensemble de capteurs de courant (200) selon l'une des revendications précédentes, dans lequel la section de résistance (114) comprend un étranglement (128), qui a une forme géométrique prédéterminée.

5. Ensemble de capteurs de courant (200) selon l'une des revendications précédentes, dans lequel le premier élément de connexion électriquement conducteur (102) est formé de manière à ce qu'une épaisseur minimale de la section de résistance (114) soit inférieure à une épaisseur minimale de la section de connexion terminale (112) et à une épaisseur minimale de la section de connexion intermédiaire (116) et/ou qu'une largeur minimale de la section de résistance (114) soit inférieure à une largeur minimale de la section de connexion terminale (112) et à une largeur minimale de la section de connexion intermédiaire (116).

6. Ensemble de capteurs de courant (200) selon l'une des revendications précédentes, dans lequel seuls la section de connexion terminale (112) du premier élément de connexion électriquement conducteur (102) et le deuxième élément de connexion électriquement conducteur (104) comprennent des moyens de connexion (118) pour intégrer l'agencement de résistances dans un circuit électrique.

7. Ensemble de capteurs de courant (200) selon l'une des revendications 1 à 6, comprenant en outre un capteur de température fixé à l'agencement de résistances (100), qui est configuré pour mesurer une deuxième température de l'agencement de résistances (100), dans lequel le circuit de traitement (204) est en outre configuré pour comparer la température déterminée de la section de résistance (114) à la deuxième température qui est mesurée avec le capteur de température.

8. Ensemble de capteurs de courant (200) selon l'une des revendications 1 à 7, dans lequel le circuit de traitement (204) est en outre configuré pour déterminer une deuxième valeur de courant du courant (I) circulant dans l'agencement de résistances (100) sur la base de la deuxième tension électrique ($U_2$) et de la deuxième résistance prédéfinie, et pour comparer la deuxième valeur de courant à la première valeur de courant.

9. Procédé de détermination d'une température d'un agencement de résistances (100), l'agencement de résistances (100) comprenant :

un premier élément de connexion électriquement conducteur (102) et un deuxième élément de connexion électriquement conducteur (104), qui sont formés d'un premier matériau électriquement conducteur présentant une première conductivité électrique spécifique ;
un premier élément de résistance (106) formé d'un premier matériau de résistance présentant une deuxième conductivité électrique spécifique, qui est inférieure à la première conductivité électrique spécifique,
dans lequel le premier élément de résistance (106) est connecté, avec une première extrémité, au premier élément de connexion électriquement conducteur (102) et, avec une deuxième extrémité, au deuxième élément de connexion électriquement conducteur (104) ;
dans lequel le premier élément de connexion électriquement conducteur (102) comprend

une section de connexion terminale (112), qui est configurée pour être reliée électriquement à un conducteur externe d'un circuit électrique ;
une section de connexion intermédiaire (116), qui est reliée à la première extrémité de l'élément de résistance ; et
une section de résistance (114), qui est agencée entre la section de connexion terminale (112) et la section intermédiaire (116) ; et

dans lequel le premier élément de résistance (106) présente une première résistance prédéfinie, et dans lequel la section de résistance (114) du premier élément de connexion électriquement conducteur présente une deuxième résistance prédéfinie ; et

le procédé comprenant les étapes consistant à :

acquérir (S702), à partir d'un circuit de mesure (202), des valeurs de mesure d'une mesure d'une première tension électrique ($U_1$) apparaissant aux bornes du premier élément de résistance (106) et d'une mesure d'une deuxième tension électrique ($U_2$) apparaissant aux bornes de la section de résistance (114) du premier élément de connexion électriquement conducteur (102) ;
déterminer (S704) une première valeur de courant d'un courant (I) circulant dans l'agencement de résistances sur la base de la première tension électrique ($U_1$) et de la première résistance prédéfinie ; et
déterminer (S706) une température de la section de résistance (114) du premier élément de connexion électriquement conducteur (102) sur la base de la première valeur de courant, de la deuxième tension électrique ($U_2$) et d'un coefficient de température stocké du premier matériau électriquement conducteur ;
**caractérisé en ce que**
les mesures de la première tension électrique ($U_1$) et de la deuxième tension électrique ($U_2$) sont effectuées indépendamment l'une de l'autre ;
la détermination de la température de la section de résistance (114) est répétée de manière itérative jusqu'à ce qu'une différence entre la température déterminée et une température de départ, qui est définie comme une température supposée de la section de résistance (114) pour la détermination de température, soit inférieure à une limite de convergence prédéfinie.

10. Procédé selon la revendication 9, comprenant en outre une étape de comparaison de la température déterminée de la section de résistance (114) à une deuxième température, qui est mesurée avec un capteur de température fixé à l'agencement de résistances (100).

11. Procédé selon l'une des revendications 9 ou 10, comprenant en outre une étape d'étalonnage consistant à déterminer la résistance de la section de résistance (114) à une température d'étalonnage définie et une étape de stockage consistant à stocker la résistance déterminée de la section de résistance (114) à la température d'étalonnage définie dans une mémoire, dans lequel l'étape d'étalonnage comprend :

l'acquisition, à partir du circuit de mesure (202), des valeurs de mesure de la première tension ($U_1$) et de la deuxième tension ($U_2$) mesurées à une température d'étalonnage ;
la détermination de la résistance $R_2(T_0)$ de la section de résistance (114) à la température d'étalonnage par

$$R_2\,(T_0) = \frac{U_2(T_0)}{U_1(T_0)} * R_1(T_0) \; ;$$

où $R_2(T_0)$ est la résistance de la section de résistance (114) à la température d'étalonnage ; $T_0$ est la température d'étalonnage, $U_1(T_0)$ est la première tension mesurée à la température d'étalonnage, $U_2(T_0)$ est la deuxième tension mesurée à la température d'étalonnage, et $R_1(T_0)$ est la résistance du premier élément de résistance à la température d'étalonnage.

**Fig. 1**

EP 4 431 950 B1

**Fig. 2**

Fig. 3

EP 4 431 950 B1

S602

Acquire the first electrical voltage $U_1$ dropping across
the first resistance element and the second electrical voltage $U_2$
dropping across the resistance section

S604

Determining a current flowing through the resistor arrangement
from the first electrical voltage and the first predefined resistance

S606

Determining a temperature of the resistance section based on
the first current value, the second electrical voltage and a stored
temperature coefficient of the first electrically conductive
material

# Fig. 4

S702

Acquire the first electrical voltage $U_1$ and the second electrical voltage $U_2$

S704

Set temperature of the resistor arrangement $T = T_N$

S712

Set $T = T_{N+1}$

S706

Determine the resistance of the resistance section

S708

Determine the measured temperature $T_{N+1}$

S710

Is $|T_{N+1} - T|$ smaller than a predefined value

NO

YES

End

**Fig. 5**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 0605800 A1
- EP 3851859 A1
- US 2022057438 A1
- DE 102019218308 A1
- US 2017089955 A1
- US 2023009467 A1
- WO 2020100979 A1
- US 2020011905 A1